# EUROPEAN PATENT SPECIFICATION

(11) **EP 3 767 006 B1**
(45) Date of publication and mention of the grant of the patent: **20.03.2024**
(21) Application number: 20186355.2
(22) Date of filing: 17.07.2020
(51) Int. Cl.: C23C 16/02, C23C 16/04, C23C 16/30, C23C 16/40, C23C 16/44, C23C 16/455, C23C 28/04, H01J 37/32

(54) **PROTECTION OF SURFACES IN PLASMA PROCESSING METHODS**
SCHUTZ VON OBERFLÄCHEN IN PLASMABEARBEITUNGSVERFAHREN
PROTECTION DE SURFACES DANS DES PROCÉDÉS DE TRAITEMENT AU PLASMA

(30) Priority: 17.07.2019 US 201962875111 P
(43) Date of publication of application: 20.01.2021
(73) Proprietor: Picosun Oy, 02150 Espoo (FI)
(72) Inventor: KOSTAMO, Juhana, 02260 Vantaa (FI); PUDAS, Marko, 02920 Espoo (FI)
(74) Representative: Heinonen & Co

(56) References cited:
- US-A1- 2015 218 700
- US-A1- 2018 265 972
- US-A1- 2018 330 923
- US-A1- 2019 078 199
- US-A1- 2020 131 634

## Description

### FIELD OF THE INVENTION

The present invention generally relates to methods of protecting surfaces in plasma processing methods, such as plasma etching. In particular, the invention concerns manufacturing of coated items resistant to plasma corrosion utilizing the methods of chemical deposition in vapour phase.

### BACKGROUND OF THE INVENTION

Chemical deposition methods, such as Chemical Vapor Deposition (CVD) and Atomic Layer Deposition (ALD), are extensively described in the art. ALD technology generally regarded as a subclass of CVD processes has proved an efficient tool for manufacturing high-quality conformal coatings on three-dimensional substrate structures.

Yttrium oxide is known to provide effective protection against halogen plasma, such as fluorine and chlorine plasma, for example, generated during plasma-assisted treatments, such as plasma etching or plasma enhanced chemical vapor deposition (PECVD), widely utilized in the integrated circuit (IC) industry.

Typically, yttrium oxide is deposited with physical vapor deposition (PVD) or CVD methods. In comparison to these techniques, ALD methods provide for entirely conformal and pinhole-free coatings on a variety of three-dimensional articles. By depositing yttrium oxide on such complex parts as showerheads, gas distribution plates, valves, etc. most prone to plasma corrosion in the equipment for plasma-assisted treatments, mentioned devices and parts thereof can be rendered with additional resistance to corrosion, in particular, plasma corrosion. This would prolong life-time of the equipment and markedly reduce costs associated with corrosion induced repair- and maintenance.

Moreover, the ALD films are cleaner and contain significantly less particles / impurities in the film, in comparison to the films deposited by CVD or PVD; therefore, ALD coated parts can be used in plasma etchers designed for the most demanding applications and technology nodes requiring ultimate purity.

Despite all advantages offered by the ALD technology for depositing materials optimal against plasma erosion (such as abovementioned yttrium oxide, for example), the existing solutions are hindered with a number of drawbacks.

Thus, the commonly used reactants and their combinations do not provide for surface chemistries that would allow deposition of essentially flawless coatings on surface features with high aspect ratio (e.g. deep cavities, holes, etc.) at high process speed. With increased process speed, quality of coating, in particular, in terms of conformality, markedly decreases. Therefore, upon deposition of some compounds, such as yttrium oxide, for example, on the high aspect ratio features, the resulted coating is incomplete or missing within some parts of those features (e.g. perforations or deepest parts of the cavities).

On the other hand, a number of ALD enabled materials, such as aluminum oxide, for example, are known to produce fully conformal coatings also in conditions of high-speed deposition.

US 2020/131634 A1 discloses a coating and a method to form the coating for a semiconductor film pre-clean and etch apparatus, wherein the coatings provide advantages, such as an ability to effectively deliver hydrogen radicals and fluorine radicals to a wafer surface in one apparatus or individually in two apparatuses; a coverage of high aspect ratio features on critical components; an operability in high temperatures exceeding 150° C.; and a protection of a part with high aspect ratio features underneath the coating, thereby preventing metal and particles on a processed wafer.

US 2019/078199 A1 discloses processes for forming metal oxyfluoride (M-O-F) layers and coatings on components for plasma processing chambers (or otherwise exposed to plasma corrosion), such as showerheads, gas distribution plates, nozzles etc.

US2018330923 and US2015218700 disclose a coated article and a method of coating an article with oxide compounds.

In this regard, an update in the field of manufacturing corrosion resistant articles with multilayer coatings is still desired, in view of addressing challenges associated with providing protective coatings on complex three-dimensional items utilized in the equipment for plasma-assisted treatments.

### SUMMARY

An objective of the present invention is to solve or to at least alleviate each of the problems arising from the limitations and disadvantages of the related art. The objective is achieved by various embodiments of a method for manufacturing corrosion-resistant coated items from profiled substrates, a related coated item and use thereof.

Thereby, in an aspect of the invention, a method for manufacturing a corrosion-resistant coated item from a profiled substrate is provided, in accordance to what is defined in the independent claim 1.

In embodiment, the method comprises: in an apparatus R1 for chemical deposition, depositing a conformal first coating layer on the profiled substrate, said first coating layer provided as a first metal compound, and, on the top of said first coating layer depositing a second coating layer provided as a second metal compound; in an apparatus R2 for plasma processing, delivering halogen-containing plasma onto the profiled substrate coated with the first- and second coating layers to produce a corrosion-resistant third coating layer, wherein said third coating layer forming the coating on the top of the second coating layer consists of a halogen-doped second metal compound.

In embodiment, upon deposition of said second coating layer, areas void of the second coating layer are established by virtue of the profiled portions of the substrate, such as recesses and/or perforations, and wherein the third coating layer forming the coating on said profiled areas consists of a halogen-doped first metal compound.

In embodiment, the third coating layer is resistant to plasma corrosion.

In embodiment, the first metal compound and the second metal compound are metal oxides. The first metal compound can be provided as aluminum oxide (Al₂O₃).

In some configurations, the second metal compound can be provided as yttrium oxide (Y₂O₃). In some other configurations, the second metal compound is selected from any one of: strontium oxide (SrO), zirconium dioxide (ZrOz), niobium dioxide (NbO₂), hafnium dioxide (HfO₂), tantalum pentoxide (Ta₂O₅) or a combination thereof.

In embodiment, halogen-containing plasma delivered onto the profiled substrate in the apparatus R2 is fluorine plasma. In some configurations, halogen-containing plasma is chlorine plasma.

In embodiment, the apparatus R1 for chemical deposition is an apparatus for chemical vapor deposition. In embodiment, the apparatus R1 for chemical deposition is an apparatus for Atomic Layer Deposition (ALD).

In embodiment, the apparatus R2 for plasma processing is selected from any one of: an apparatus for plasma-enhanced chemical vapor deposition, an apparatus for plasma-assisted physical vapor deposition or a plasma etcher.

In embodiment, the profiled substrate is made of material selected from the group consisting of: metal, metal alloy, quartz, semiconductor, and ceramics.

In another aspect, a corrosion-resistant coated item is provided, in accordance to what is defined in the independent claim 8.

In embodiment, the corrosion-resistant coated item comprises: a profiled substrate with a conformal first coating layer deposited thereon, said first coating layer is provided as a first metal compound, a second coating layer deposited on the top of said first coating layer and provided as a second metal compound, and a third coating layer, wherein said third coating layer forming on the top of the second coating layer consists of a halogen-doped second metal compound.

In embodiment, the coated item comprises areas void of the second coating layer, said void areas being established, upon deposition of the second coating layer, by virtue of the profiled portions of the substrate, such as recesses and/or perforations, wherein the third coating layer forming on said profiled areas (areas void of the second coating layer) consists of a halogen-doped first metal compound.

In embodiment, the third coating layer is resistant to plasma corrosion. In embodiment, the third coating layer is resistant to halogen plasma corrosion.

In embodiment, the halogen compound in the third coating layer is fluorine or chlorine.

In embodiment, the profiled substrate is made of material selected from the group consisting of: metal, metal alloy, quartz, semiconductor, and ceramics.

In embodiment, the coated item is configured as a component used in equipment for plasma processing, said component selected from the group consisting of: a showerhead, a diffusor for the showerhead, a pedestal, a sample holder, a valve, a valve block, a pin, a manifold, a pipe, a cylinder, a lid, and a container.

In still further aspect, use of the coated item according to some previous aspect in an equipment for plasma-assisted treatments, selected from plasma etching, plasma-enhanced chemical vapor deposition and physical vapor deposition, is provided, in accordance to what is defined in the independent claim 17.

The embodiments of the invention become apparent from the dependent claims.

The utility of the present invention arises from a variety of reasons depending on each particular embodiment thereof. The method provides for manufacturing corrosion resistant items from profiled substrates, such as showerheads and diffusors for showerhead, with a triple protective layer that combines a fully conformal- and a non-conformal ALD coating layers to create a working solution. Additionally, the method comprises generation of a third coating layer during a curing process in a plasma processing apparatus, wherein the substrate surface is further modified and passivated by halogen plasma. Such an arrangement is advantageous in view that after using a highly toxic halogen (e.g. fluorine) plasma, the cured substrate remains in the plasma processing apparatus, i.e. further transfer of the cured substrate elsewhere is not required.

The method thus enables production of a coating film stack optimal, in view of a number of layers and composition thereof, for shielding complex, often perforated structures, such as showerheads, pedestals, pipes, valves and manifolds of semiconductor equipment or other metal substrates, against corrosion.

The method further allows for extending operational lifetime for the etcher components, i.e. time the components are in operation before maintenance, such as by more than twice of time as compared to other processes that utilize less optimal precursors for yttrium oxide. Additionally, processing time for preparing the protective coating is reduced, in particular, compared to the present methods that require very long purging periods, which are longer than one minute for the highest aspect ratio features.

In the present disclosure, materials with a layer thickness below 10 micrometers (µm) are referred to as "thin films".

The expression "a number of" refers herein to any positive integer starting from one (1), e.g. to one, two, or three; whereas the expression "a plurality of" refers herein to any positive integer starting from two (2), e.g. to two, three, or four.

The terms "first" and "second" are not intended to denote any order, quantity, or importance, but rather are used to merely distinguish one element from another.

### BRIEF DESCRIPTION OF THE DRAWINGS

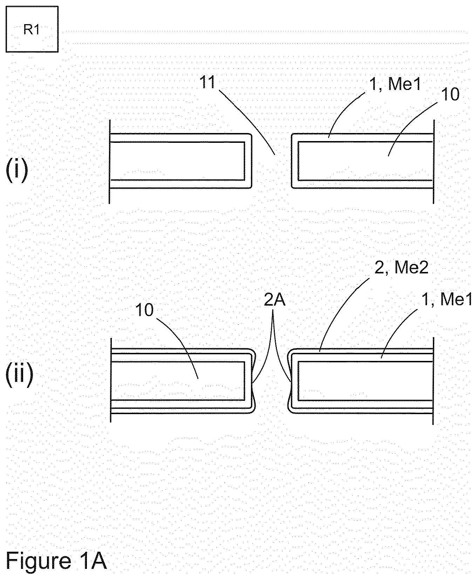

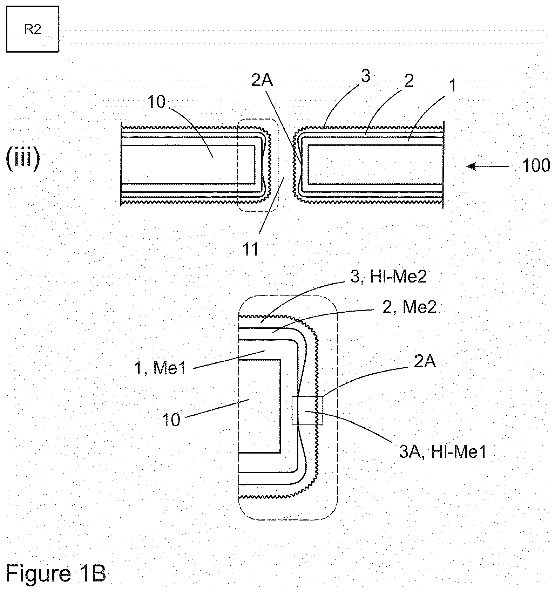

Figs. 1A and 1B schematically illustrate a method for manufacturing a coated item 100 from a profiled substrate 10, according to the embodiments.

### DETAILED DESCRIPTION OF THE EMBODIMENTS

Figs. 1A and 1B schematically illustrate a concept underlying various embodiments of a method for manufacturing a coated item 100, resistant to plasma corrosion, from a profiled substrate 10.

The profiled substrate 10 is provided as a three-dimensional object suitable for coating by chemical deposition methods. The inventive concept is particularly applicable to the profiled substrates that contain high aspect ratio features 11, such as recesses and/or perforations, referred to as "profiles". The profiled substrate can thus be configured as a perforated substrate, a substrate having a patterned surface or a combination of perforations with the patterned surface. The profiles can be configured discrete (e.g. in the form of discrete, individual apertures / holes) or continuous, such as grooves, channels (including through-cut channels), trenches, and the like. While the perforations can be described as through-holes or channels penetrating throughout the substrate; the recesses are described as blind-end holes. Profiled portions of various sizes and shapes can be conceived.

In embodiments, the profiled substrate is configured as a component used in equipment for plasma processing, such as plasma etchers, reactors for plasma-enhanced chemical vapor deposition (PECVD) or for plasma-assisted physical vapor deposition (PVD). In various configurations, the substrate can be provided as a showerhead, a diffusor for the showerhead, a pedestal, a sample holder, a valve, a valve block, a pin, a manifold, a pipe, a cylinder, a lid, and a container.

Material, the profiled substrate 10 is made of, can be any one of metal, metal alloy, quartz, semiconductor (e.g. silicon) or ceramics.

Fig. 1A illustrate stages (i, ii) of the manufacturing method disclosed hereby conducted in an apparatus for chemical deposition (R1).

The apparatus R1 for chemical deposition can be configured as a reactor for chemical vapor deposition (CVD). In some configurations, the apparatus R1 can be configured as an apparatus for Atomic Layer Deposition (ALD) or an apparatus for Molecular Layer Deposition (MLD).

In atomic layer deposition processes, the at least one substrate (e.g. a metal- or a semiconductor wafer) is typically exposed to temporally separated precursor pulses in a reaction vessel to deposit material on the substrate surfaces by sequential self-saturating surface reactions.

ALD is based on alternating self-saturative surface reactions, wherein different reactants (precursors) provided as chemical compounds or elements in a nonreactive (inert) gaseous carrier are sequentially pulsed into a reaction space accommodating a substrate. A basic ALD deposition cycle, resulting in deposition of a deposition layer (atomic layer), consists of four sequential steps: pulse A, purge A, pulse B and purge B. Pulse A consists of a first precursor fluid and pulse B of another precursor fluid. Inert gas and a vacuum pump are typically used for purging gaseous reaction by-products and the residual reactant molecules from the reaction space during purge A and purge B. A deposition sequence comprises at least one deposition cycle. Deposition cycles are repeated until the deposition sequence has produced a thin film or coating of desired thickness. Deposition cycles can also be either simpler or more complex. For example, the cycles can include three or more reactant vapor pulses separated by purging steps, or certain purge steps can be omitted. On the other hand, photo-enhanced ALD has a variety of options, such as only one active precursor, with various options for purging. All these deposition cycles form a timed deposition sequence that is controlled by a logic unit or a microprocessor.

A layer of material formed in a conventional ALD cycle is typically 0,05 - 0,2 nm thick. The cycle is repeated as many times as required for obtaining a film with a predetermined thickness.

In terms of an overall implementation, the chemical deposition reactor may be based on an ALD installation described in the U.S. patent no. 8211235 (Lindfors), for example, or an ALD installation trademarked as the PICOSUN^{™} P-300B ALD system or the PICOSUN^{™} P-1000 ALD system available from Picosun Oy, Finland. Nevertheless, the features underlying a concept of the present invention can be incorporated into any other chemical deposition reactor embodied as an ALD, MLD or CVD device, for example, or any subtype thereof, such as photon-enhanced Atomic Layer Deposition (known also as photo-ALD or flash enhanced ALD), for example.

The reactor R1 comprises a reaction chamber for accommodating, typically in a substrate holder, a substrate or substrates 10 to be coated. The reactor R1 further comprises a number of appliances configured to mediate a flow of fluids into the reaction space (the reaction chamber). Mentioned appliances are provided as a number of intake lines (hereafter, feedlines) and associated switching and/or regulating valves (not shown).

Fig. 1A illustrates, at (i) deposition of a first coating layer 1 (a first surface layer 1) onto the profiled substrate 10 configured as an exemplary diffusor device for a showerhead device utilized in PECVD methods, for example.

Diffusors for showerhead devices are known from the art. Such diffusor device is generally configured as a plate (embodied as the substrate 10 at Figs. 1A, 1B) with a plurality of apertures or through-cut passages 11 optionally arranged into a pattern.

As shown on Fig. 1A (i), the first coating layer 1 is entirely conformal and covers all surfaces of the profiled substrate 10 exposed to reactive chemicals.

The first coating layer 1 is formed by a first metal compound (Me1). In an exemplary embodiment, the first metal compound, that forms said first coating layer, is aluminum oxide (Al₂O₃), produced by the exemplary ALD process via sequential reactions of trimethylaluminum (TMA, Al(CH₃)₃) used as precursor A and water used as precursor B. Between precursor pulses the reaction chamber is purged with inert gas (e.g. nitrogen, N₂).

In some other configurations, the first coating layer 1 can be formed by other metal oxides, such as titanium (di)oxide (TiO₂), for example.

Hence, at (i) the substrate (configured as the diffusor plate, for example) is provided with the first coating layer 1 that fully conforms to the substrate topology. The first coating layer is preferably provided as a thin film (having thickness 0,1 nm - 1 µm).

In the reactor R1, the method continues, at (ii) by depositing a second coating layer 2 (a second surface layer 2) on the top of the first coating layer 1. The second coating layer is formed by a second metal compound (Me2), accordingly.

In preferred embodiment, the second metal compound Me2 is yttrium oxide (Y₂O₃). Yttrium oxide coatings are known as one of the best components to provide effective barrier protection against plasma corrosion, such as halogen (e.g. fluorine and chlorine) plasma corrosion for parts and components utilized in plasma processing equipment and methods. The second coating layer 2 provided as yttrium oxide is deposited via the ALD process by using an yttrium oxide precursor, such as a cyclopentadienyl-based precursor, for example, as precursor A and water as precursor B. Exemplary precursors include tris(ethylcyclopentadienyl)yttrium (III) and tris(butylcyclopentadienyl)yttrium (III)). Any other appropriate precursor may be utilized.

However, upon optimized ALD deposition (e.g. involving high process speed) of said second coating layer 2 comprising the second metal compound configured as yttrium oxide, the coating conformality is markedly decreased for the high aspect ratio features 11, such as recesses and/or perforations in the substrate 10. Hence, due to surface chemistries, a substrate 10 configured as the exemplary plate for the showerhead device and thus having deep cavities or perforations 11 cannot be ALD-coated by yttrium oxide with as short purging times as it could be coated with aluminum oxide (i.e. full conformality cannot be achieved fast, such as in a time period less than about 30 seconds for example). By the process(es) involving high process speed we refer to chemical deposition (e.g. ALD) processes, wherein the time period the second precursor spends in the reaction chamber is typically insufficient for said second precursor to react with all profiled portions 2A of the substrate, such as pores and cavities, for example. Time period the precursor spends in the reaction chamber is regulated e.g. by adjusting pressure and temperature (in- and outside the reaction chamber), regulating precursor flow and temperature of precursor flow, and/or by adjusting the aspect ratio of the profiled portions on the sample.

In this regard, upon deposition of said second coating layer 2, uncoated areas 2A remain at the profiled portions of the substrate 10, such as recesses and/or perforations. The second surface layer 2 is thus characterized by uneven topography due to formation of the areas 2A, established by virtue of the profiled portions 11, said areas 2A being short of or completely void of the second coating layer (second metal compound Me2). Deposition of the second surface layer is thus non-conformal. As shown on Fig. 1A (ii), transition from an essentially conformal portion (2, Me2) towards the void area 2A is typically gradual. Such graduality can be explained by the fact that some reactive chemicals, such as yttrium precursors, arriving onto the perforated substrate 10 (from all directions) do not reach areas 2A (Fig. 1A, ii) formed by the lateral portions of the passages 11 located essentially center-wise with regard to the substrates' (upper and lower) surfaces. The lateral portions of the passages 11 are represented on Fig. 1A as vertical sidewalls provided on both sides of the passage 11.

The process disclosed hereby further allows for depositing of the second coating layer 2 having full conformality to the substrate 10 (previously deposited with the first coating layer 1). This can be attained by adjusting deposition parameters and/or by selecting metal compounds with different surface chemistry.

In some configurations the second metal compound is provided as strontium oxide (SrO), zirconium (di)oxide (ZrOz), niobium (di)oxide (NbO₂), hafnium (di)oxide (HfOz), tantalum (pent)oxide (Ta₂O₅), or a combination thereof.

In embodiments, the first- and the second coating layers are metal oxides. Still, in some instances, provision of any one of the coating layers 1, 2 formed by metal nitride, metal carbide, metal fluoride or another compound suitable for being deposited by chemical deposition methods, is not excluded.

In some configurations, the apparatus R1 for chemical deposition can employ a heated inlet, as described in the International application publication WO/2017/178690 assigned to Picosun Oy, Finland, which inlet can rapidly heat incoming gas to temperatures higher than the reaction temperature. Hence, the second precursor or inert carrier gas (such as N₂) can be heated to higher temperatures than the reaction chamber, thus improving removal of the ligand from the yttrium oxide precursor. For clarity, in an ALD deposition cycle for depositing yttrium oxide said second precursor/B is water, whereas the first precursor/A can be a precursor based on a cyclopentadienyl ligand, as described herein above.

In some instances, removal of the ligand from the yttrium oxide precursor can be improved, in ALD, by replacement reactions (so called three-step ABC reactions), such as those involving a third pulse (e.g. aluminum chloride, AlCl₃) after the pulse with the yttrium oxide precursor (precursor A) (and prior the pulse with water as precursor B). In particular, coating of the high aspect ratio surface features, such as deep trenches, with yttrium oxide, is in most instances incomplete or missing; however, by the procedure involving replacement reactions those surfaces can be doped with aluminium metal (Al). Provision of metallic aluminium on the surfaces is indeed more preferred that a complete lack of yttrium oxide coating, in particular, in circumstances when the first coating 1 formed by the aluminum oxide is provided.

In some instances, in order to allow the precursor to remain in the reaction chamber for a longer period (whereby the reactant is not purged out from the reaction chamber immediately), it can be further advantageous to use changing pressure in the chemical deposition reactor R1 during the deposition cycle. This can be implemented by adjusting flow (pressure) to an exhaust pump fore-line by stop-flow processes or modifications thereof.

After formation of the second coating layer 2, the substrate or substrates 10 is transferred from the apparatus R1 for chemical deposition to the apparatus R2 for plasma processing (step iii, Fig. 1B). The reactor R2 can be provided as an apparatus for plasma-enhanced chemical vapor deposition, an apparatus for plasma-assisted physical vapor deposition or a plasma etcher.

In the plasma processing apparatus R2, the profiled substrate 10 is installed such, as to render the apparatus R2 fully operable without a need to further remove or change a position of the substrate 10 within the reactor after the step (iii). In an event the profiled substrate 10 is configured as a showerhead or a diffusor for the showerhead, the substrate 10 is installed into the reactor R2 as a showerhead / a diffusor for dispensing gas(es) over a wafer. Hence, during the step (iii) in the reactor R1, the substrate 10 does not take the place of a sample (a wafer).

The method continues at (iii), Fig. 1B, wherein in the reactor R2 for plasma processing, plasma containing halogen species is delivered onto the profiled substrate 10 coated with the first- and second coating layers. Halogen ions formed during plasma-assisted processing collide with the topmost coating layer and implant into said layer thus producing a halogen-doped surface layer 3, 3A, referred to as a third coating layer.

Hence, the third coating layer forming the coating 3 on the top of the second coating layer 2 consists of a halogen-doped second metal compound (HI-Me2), whereas the third coating layer forming the coating 3A on the profiled areas 2A consists of a halogen-doped first metal compound (Hl-Me1). For clarity, the third coating layer forming the coating on the top of the second coating layer 2 is designated by reference numeral 3, and the third coating layer forming the coating on the profiled areas 2A is designated by reference numeral 3A, accordingly.

In some configurations, the third coating layer3, 3A is a heterogeneous layer having portions 3 formed by halogen-doped second metal compound (e.g. halogen doped yttrium oxide) and portions 3A formed by halogen-doped first metal compound (e.g. halogen-doped aluminum oxide). The portions 3A are formed within the recesses, perforations, etc., i.e. areas being out of reach of the second metal compound Me2 during step (ii), Fig. 1A.

In some configurations, when the substrate does not comprise profiled portions and the second coating layer 2 is fully conformal to said substrate, the third coating layer 3 is formed on the entire substrate by the halogen-doped second metal compound (HI-Me2).

In the method, the substrate 10 pre-coated with the first coating and at least partially with the second coating can be contacted, at (iii), with plasma containing fluorine. For deposition/doping, fluorine plasma is preferably cold plasma produced by an electrical discharge in gaseous media, such as SF₆, CF₄, CHF₃ or C₄F₈ gases. Utilization of thermal plasma techniques is still not excluded. Alternatively the fluoride doping is implemented with fluoride ions at elevated temperatures, up to 350 °C.

In some configurations, chlorine-containing plasma can be utilized. Other halogen species, including bromine and iodine, can be utilized whether appropriate.

Curing of the substrate 10 coated with the first coating layer and, at least partially, with the second coating layer results in formation of a cured surface layer (third coating layer 3) resistant to corrosion. In particular, said third coating layer is resistant to plasma corrosion, optionally caused by halogen-containing plasma.

In an example, the substrate surfaces pre-coated by the first- and the second coating layers 1, 2 (Al₂O₃, Y₂O₃) are further doped with fluoride ions. An exemplary process is carried out in the PECVD tool, which typically exploits fluorine for plasma processes. Fluoride doping (iii, Fig. 1B) is implemented at 300 - 350 °C to the topmost layer (which is either the second coating layer formed by Y₂O₃ or the first coating layer formed by Al₂O₃ in the areas 2A that lack the second coating layer). The same process can be implemented in the etcher tool at low plasma power.

In some configurations, the halogen-doped first metal compound (HI-Me1) is aluminum fluoride (AlF₃), whereas the halogen-doped second metal compound (HI-Me2) is an oxyfluoride compound with composition Me2ₓOF_{y}, wherein Me2 is any one of yttrium, strontium, zirconium, niobium, hafnium or tantalum.

In an aspect, a corrosion-resistant coated item 100 (Fig. 1B) formed from the profiled substrate 10 is provided, said item comprising the profiled substrate 10 with a triple layer film 1, 2, 3 protecting the substrate from corrosion, In particular, from plasma-induced corrosion.

The coated item 100 thus comprises the first coating layer 1 conformal to the substrate and formed by the first metal compound (Me1), the second coating layer 2 deposited on the top of said first coating layer 1 and formed by the second metal compound (Me2), and the third coating layer 3, 3A. The first- and the second metal compounds are preferably metal oxides, described herein above.

In embodiment, the third coating layer forming the coating 3 on the top of the second coating layer 2 consists of a halogen-doped second metal compound (HI-Me2).

In some embodiments, the coated item 100 comprises areas 2A void of the second coating layer 2 established upon non-conformal deposition of the second coating layer 2 on the top of the (fully conformal) first coating layer 1. The areas 2A are formed at the high aspect ratio (profiled) portions 11 of the substrate, such as recesses and/or perforations. The third coating layer forming the coating 3A on said profiled areas 2A thus consists of a halogen-doped first metal compound (Hl-Me1).

In an example, the coated item 100 configured as a profiled substrate 10, such as a diffusor device for a showerhead device, comprises, at essentially flat, planar portions thereof, a triple layer film (1, 2, 3) comprising the third coating layer (YₓOF_{y}) on the top, the second coating layer (Y₂O₃) in the middle and the first coating layer (Al₂O₃) in the bottom. Such triple layer film is sufficient to withstand ion bombardment in plasma processing more effectively than solutions known from the art. Within the diffusor perforations the first coating layer is provided (due to fully conformal coating by e.g. aluminum oxide), which becomes halogen-doped upon plasma curing (stage iii, Fig. 1B). The latter process is associated with formation of aluminium fluoride (AlF₃) on the top of the structure, as the third coating layer, which is sufficient to withstand less aggressive bombardment by ions. In other words, provision of a double layer film (1, 3A) within perforations or deep cavities is sufficient, since mentioned high aspect ratio features do not typically undergo the most intensive corrosion upon plasma treatment.

Provision of the third coating layer in a separate apparatus R2 allows for further modifying and passivating the coated substrate surfaces by halogen plasma in a plasma etcher or in PECVD or PVD tool.

The last stage of the method (iii, Fig. 1B) can be omitted. This is particularly advantageous in an event when the substrate coated by 1, 2 is placed into conditions where atmospheric oxygen can attack the surface to be coated. For example, the substrate 10 coated by the first and second coatings can be a component suitable to construct the outer surfaces of an object for use in space, such as a satellite, in particular, a low earth orbit (LEO) satellite.

It shall be appreciated by those skilled in the art that the embodiments set forth in the present disclosure may be adapted and combined as desired. The disclosure is thus intended to encompass any possible modifications of the device and the deposition method, recognizable by those of ordinary skill in the art, within a scope of appended claims.

## Claims

1. A method for manufacturing a corrosion-resistant coating on a profiled substrate (10), the method comprising:
in an apparatus (R1) for chemical deposition, depositing a conformal first coating layer (1) on the profiled substrate (10), said first coating layer (1) provided as a first metal compound (Me1), and, on the top of said first coating layer (1) depositing a second coating layer (2) provided as a second metal compound (Me2), said first metal compound (Me1) and said second metal compound (Me2) being metal oxides,
in an apparatus (R2) for plasma processing, delivering halogen-containing plasma onto the profiled substrate (10) coated with the first- and second coating layers to produce a corrosion-resistant third coating layer (3, 3A),
wherein said third coating layer forming the coating (3) on the top of the second coating layer (2) consists of a halogen-doped second metal compound (HI-Me2),
wherein, upon deposition of said second coating layer (2), areas (2A) void of the second coating layer are established by virtue of the profiled portions (11) of the substrate, such as recesses and/or perforations, and wherein the third coating layer forming the coating (3A) on said profiled areas (2A) consists of a halogen-doped first metal compound (HI-Me1).

2. The method of claim 1, wherein the third coating layer (3, 3A) is resistant to plasma corrosion, in particular, to halogen plasma corrosion, wherein halogen-containing plasma is fluorine plasma or chlorine plasma.

3. The method of claim 1, wherein the first metal compound is aluminum oxide (Al₂O₃), and wherein the second metal compound is yttrium oxide (Y₂O₃).

4. The method of claim 1, wherein the second metal compound is selected from any one of: strontium oxide (SrO), zirconium dioxide (ZrO₂), niobium dioxide (NbO₂), hafnium dioxide (HfO₂), tantalum pentoxide (Ta₂O₅) or a combination thereof.

5. The method of claim 1, wherein the halogen-doped first metal compound (HI-Me1) is aluminum oxyfluoride of formula Me1ₓOF_{y}.

6. The method of claim 1, wherein the halogen-doped second metal compound (HI-Me2) is an oxyfluoride compound with composition Me2ₓOF_{y}, wherein Me2 is any one of yttrium, strontium, zirconium, niobium, hafnium or tantalum.

7. The method of any preceding claim, wherein the apparatus (R1) for chemical deposition is an apparatus for chemical vapor deposition, such as an apparatus for Atomic Layer Deposition (ALD), and wherein the apparatus (R2) for plasma processing is selected from any one of: an apparatus for plasma-enhanced chemical vapor deposition, an apparatus for plasma-assisted physical vapor deposition or a plasma etcher.

8. A corrosion-resistant coated three-dimensional object (100) comprising:
a profiled substrate (10) with a conformal first coating layer (1) deposited thereon, said first coating layer (1) is provided as a first metal compound (Me1),
a second coating layer (2) deposited on the top of said first coating layer (1) and provided as a second metal compound (Me2), said first metal compound (Me1) and said second metal compound (Me2) being metal oxides, and
a third coating layer (3, 3A),
wherein said third coating layer forming the coating (3) on the top of the second coating layer (2) consists of a halogen-doped second metal compound (HI-Me2),
said corrosion-resistant three-dimensional object further comprising areas (2A) void of the second coating layer, the areas (2A) established upon deposition of the second coating layer (2) by virtue of the profiled portions (11) of the substrate, such as recesses and/or perforations, wherein the third coating layer forming the coating (3A) on said profiled areas (2A) consists of a halogen-doped first metal compound (HI-Me1).

9. The corrosion-resistant coated three-dimensional object (100) of claim 8, wherein the third coating layer (3, 3A) is resistant to plasma corrosion, in particular, to halogen plasma corrosion.

10. The corrosion-resistant coated three-dimensional object (100) of claim 8, wherein the first metal compound is aluminum oxide (Al₂O₃) and wherein the second metal compound is yttrium oxide (Y₂O₃).

11. The corrosion-resistant coated three-dimensional object (100) of claim 8, wherein the second metal compound is selected from any one of: strontium oxide (SrO), zirconium dioxide (ZrO₂), niobium dioxide (NbO₂), hafnium dioxide (HfO₂), tantalum pentoxide (Ta₂O₅) or a combination thereof.

12. The corrosion-resistant coated three-dimensional object (100) of claim 8, wherein the halogen-doped first metal compound (HI-Me1) is aluminum oxyfluoride of formula Me1ₓOF_{y}.

13. The corrosion-resistant coated three-dimensional object (100) of claim 8, wherein the halogen-doped second metal compound (HI-Me2) is an oxyfluoride compound with composition Me2ₓOF_{y}, wherein Me2 is any one of yttrium, strontium, zirconium, niobium, hafnium or tantalum.

14. The corrosion-resistant coated three-dimensional object (100) of any one of claims 8-13, wherein the halogen compound in the third coating layer (3, 3A) is fluorine or chlorine.

15. The corrosion-resistant coated three-dimensional object (100) of any one of claims 8-14, wherein the profiled substrate (10) is made of material selected from the group consisting of: metal, metal alloy, quartz, semiconductor, and ceramics.

16. Use of a coated three-dimensional object (100) as defined in any one of claims 8-15 in an equipment for plasma processing, the coated three-dimensional object being configured as an equipment component selected from the group consisting of: a showerhead, a diffusor for the showerhead, a pedestal, a sample holder, a valve, a valve block, a pin, a manifold, a pipe, a cylinder, a lid, and a container.

17. Use of a coated three-dimensional object (100) as defined in any one of claims 8-15 in an equipment for plasma-assisted treatments, the coated three-dimensional object being configured as a component of the equipment selected from plasma etching, plasma-enhanced chemical vapor deposition and physical vapor deposition.

## Patentansprüche

1. Verfahren zum Herstellen einer korrosionsbeständigen Beschichtung auf einem profilierten Trägermaterial (10), das Verfahren umfassend:
Abscheiden einer konformen ersten Überzugsschicht (1) auf dem profilierten Trägermaterial (10) in einer Vorrichtung (R1) zur chemischen Abscheidung, wobei die erste Überzugsschicht (1) als eine erste Metallverbindung (Me1) bereitgestellt ist, und Abscheiden einer zweiten Überzugsschicht (2), die als eine zweite Metallverbindung (Me2) bereitgestellt ist, auf der ersten Überzugsschicht (1), wobei die erste Metallverbindung (Me1) und die zweite Metallverbindung (Me2) Metalloxide sind,
Zuführen eines halogenhaltigen Plasmas an das mit der ersten und zweiten Überzugsschicht beschichtete profilierte Trägermaterial (10) in einer Vorrichtung (R2) zur Plasmaverarbeitung, um eine korrosionsbeständige dritte Überzugsschicht (3, 3A) herzustellen,
wobei die dritte Überzugsschicht, die die Beschichtung (3) auf der zweiten Überzugsschicht (2) bildet, aus einer mit Halogen dotierten zweiten Metallverbindung (Hl-Me2) besteht,
wobei beim Abscheiden der zweiten Überzugsschicht (2) aufgrund der profilierten Abschnitte (11) des Trägermaterials, zum Beispiel Aussparungen und/oder Perforationen, Bereiche (2A) ohne zweite Überzugsschicht gebildet werden, und wobei die dritte Überzugsschicht (3A) auf den profilierten Bereichen (2A) aus einer mit Halogen dotierten ersten Metallverbindung (Hl-Me1) besteht.

2. Verfahren nach Anspruch 1, wobei die dritte Überzugsschicht (3, 3A) resistent gegenüber Plasmakorrosion ist, insbesondere gegenüber Halogenplasmakorrosion, wobei das halogenhaltige Plasma Fluorplasma oder Chlorplasma ist.

3. Verfahren nach Anspruch 1, wobei die erste Metallverbindung Aluminiumoxid (Al₂O₃) ist, und wobei die zweite Metallverbindung Yttriumoxid (Y₂O₃) ist.

4. Verfahren nach Anspruch 1, wobei die zweite Metallverbindung aus den Folgenden ausgewählt ist: Strontiumoxid (SrO), Zirkondioxid (ZrO₂), Niobdioxid (NbO₂), Hafniumdioxid (HfO₂), Tantalpentoxid (Ta₂O₅) oder eine Kombination davon.

5. Verfahren nach Anspruch 1, wobei die mit Halogen dotierte erste Metallverbindung (Hl-Me1) Aluminiumoxyfluorid der Formel Me1ₓOF_{y} ist.

6. Verfahren nach Anspruch 1, wobei die mit Halogen dotierte zweite Metallverbindung (Hl-Me2) eine Oxyfluoridverbindung mit der Zusammensetzung Me2ₓOF_{y} ist, wobei Me2 eines aus Yttrium, Strontium, Zirkon, Niob, Hafnium oder Tantal ist.

7. Verfahren nach einem der vorhergehenden Ansprüche, wobei die Vorrichtung (R1) zur chemischen Abscheidung eine Vorrichtung zur chemischen Gasphasenabscheidung ist, zum Beispiel eine Vorrichtung zur Atomlagenabscheidung (ALD), und wobei die Vorrichtung (R2) zur Plasmaverarbeitung aus den Folgenden ausgewählt ist: eine Vorrichtung zur Plasma-gestützten chemischen Gasphasenabscheidung, eine Vorrichtung zur Plasma-gestützten physischen Gasphasenabscheidung oder ein Plasmaätzer.

8. Korrosionsbeständiges beschichtetes dreidimensionales Objekt (100), umfassend:
ein profiliertes Trägermaterial (10) mit einer konformen ersten Überzugsschicht (1), die darauf abgeschieden ist, wobei die erste Überzugsschicht (1) als erste eine Metallverbindung (Me1) bereitgestellt ist,
eine zweite Überzugsschicht (2), die auf der ersten Überzugsschicht (1) abgeschieden ist und als eine zweite Metallverbindung (Me2) bereitgestellt ist, wobei die erste Metallverbindung (Me1) und die zweite Metallverbindung (Me2) Metalloxide sind, und
eine dritte Überzugsschicht (3, 3A),
wobei die dritte Überzugsschicht, die die Beschichtung (3) auf der zweiten Überzugsschicht (2) bildet, aus einer mit Halogen dotierten zweiten Metallverbindung (Hl-Me2) besteht,
wobei das korrosionsbeständige dreidimensionale Objekt ferner Bereiche (2A) ohne die zweite Überzugsschicht umfasst, wobei die Bereiche (2A) aufgrund der profilierten Abschnitte (11) des Trägermaterials, zum Beispiel Aussparungen und/oder Perforationen, beim Abscheiden der zweiten Überzugsschicht (2) gebildet werden, wobei die dritte Überzugsschicht (3A) auf den profilierten Bereichen (2A) aus einer mit Halogen dotierten ersten Metallverbindung (Hl-Me1) besteht.

9. Korrosionsbeständiges beschichtetes dreidimensionales Objekt (100) nach Anspruch 8, wobei die dritte Überzugsschicht (3, 3A) resistent gegenüber Plasmakorrosion ist, insbesondere gegenüber Halogenplasmakorrosion.

10. Korrosionsbeständiges beschichtetes dreidimensionales Objekt (100) nach Anspruch 8, wobei die erste Metallverbindung Aluminiumoxid (Al₂O₃) ist, und wobei die zweite Metallverbindung Yttriumoxid (Y₂O₃) ist.

11. Korrosionsbeständiges beschichtetes dreidimensionales Objekt (100) nach Anspruch 8, wobei die zweite Metallverbindung aus den Folgenden ausgewählt ist: Strontiumoxid (SrO), Zirkondioxid (ZrO₂), Niobdioxid (NbO₂), Hafniumdioxid (HfO₂), Tantalpentoxid (Ta₂O₅) oder eine Kombination davon.

12. Korrosionsbeständiges beschichtetes dreidimensionales Objekt (100), nach Anspruch 8, wobei die mit Halogen dotierte erste Metallverbindung (Hl-Me1) Aluminiumoxyfluorid der Formel Me1ₓOF_{y} ist.

13. Korrosionsbeständiges beschichtetes dreidimensionales Objekt (100), nach Anspruch 8, wobei die mit Halogen dotierte zweite Metallverbindung (Hl-Me2) eine Oxyfluoridverbindung mit der Zusammensetzung Me2ₓOF_{y} ist, wobei Me2 eines aus Yttrium, Strontium, Zirkon, Niob, Hafnium oder Tantal ist.

14. Korrosionsbeständiges beschichtetes dreidimensionales Objekt (100) nach einem der Ansprüche 8 bis 13, wobei die Halogenverbindung in der dritten Überzugsschicht (3, 3A) Fluor oder Chlor ist.

15. Korrosionsbeständiges beschichtetes dreidimensionales Objekt (100) nach einem der Ansprüche 8 bis 14, wobei das profilierte Trägermaterial (10) aus Material besteht, das aus der Gruppe, die aus Metall, Metalllegierung, Quarz, Halbleiter und Keramik besteht, ausgewählt ist.

16. Verwendung eines beschichteten dreidimensionalen Objekts (100), wie in einem der Ansprüche 8 bis 15 definiert, in einem Gerät zur Plasmaverarbeitung, wobei das beschichtete dreidimensionale Objekt als Gerätekomponente, die aus der Gruppe, die aus einem Duschkopf, einem Diffusor für den Duschkopf, einem Sockel, einem Probenhalter, einem Ventil, einem Ventilblock, einem Stift, einem Verteiler, einem Rohr, einem Zylinder, einem Deckel und einem Behälter besteht, ausgewählt ist, konfiguriert ist.

17. Verwendung eines beschichteten dreidimensionalen Objekts (100), wie in einem der Ansprüche 8 bis 15 definiert, in einem Gerät für Plasma-gestützte Behandlungen, wobei das beschichtete dreidimensionale Objekt als eine Komponente des Geräts, das aus Plasmaätzen, Plasma-gestützter chemischer Gasphasenabscheidung und physischer Gasphasenabscheidung ausgewählt ist, konfiguriert ist.

## Revendications

1. Procédé de fabrication d'un revêtement résistant à la corrosion sur un substrat profilé (10), le procédé comprenant les étapes consistant à :
dans un appareil (R1) pour le dépôt chimique, déposer une première couche de revêtement conforme (1) sur le substrat profilé (10), ladite première couche de revêtement (1) étant fournie comme un premier composé métallique (Me1), et, sur la partie supérieure de ladite première couche de revêtement (1), déposer une seconde couche de revêtement (2) fournie comme un second composé métallique (Me2), ledit premier composé métallique (Me1) et ledit second composé métallique (Me2) étant des oxydes de métal,
dans un appareil (R2) pour le traitement au plasma, délivrer un plasma contenant un halogène sur le substrat profilé (10) revêtu avec les première et deuxième couches de revêtement pour produire une troisième couche de revêtement résistante à la corrosion (3, 3A),
ladite troisième couche de revêtement formant le revêtement (3) sur la partie supérieure de la deuxième couche de revêtement (2) étant constituée d'un second composé métallique dopé par un halogène (Hl-Me2),
après le dépôt de ladite deuxième couche de revêtement (2), les vides de surfaces (2A) de la deuxième couche de revêtement sont établis en vertu des parties profilées (11) du substrat, tels que des retraits et/ou des perforations et la troisième couche de revêtement formant le revêtement (3A) sur lesdites surfaces profilées (2A) étant constituée d'un premier composé métallique dopé par un halogène (Hl-Me1).

2. Procédé selon la revendication 1, dans lequel la troisième couche de revêtement (3, 3A) est résistante à la corrosion par plasma, en particulier la corrosion par plasma d'halogène, le plasma contenant un halogène étant un plasma de fluor ou un plasma de chlore.

3. Procédé selon la revendication 1, dans lequel le premier composé métallique est l'oxyde d'aluminium (Al₂O₃) et le second composé métallique étant l'oxyde d'yttrium (Y₂O₃) .

4. Procédé selon la revendication 1, dans lequel le second composé métallique est choisi parmi l'un quelconque de : l'oxyde de strontium (SrO), le dioxyde de zirconium (ZrO₂), le dioxyde de niobium (NbO₂), le dioxyde d'hafnium (HfO₂), le pentoxyde de tantale (Ta₂O₅) ou une de leurs combinaisons.

5. Procédé selon la revendication 1, dans lequel le premier composé métallique (Hl-Me1) dopé par un halogène est l'oxyfluorure d'aluminium de formule Me1ₓOF_{y}.

6. Procédé selon la revendication 1, dans lequel le second composé métallique (Hl-Me2) dopé par un halogène est un composé oxyfluorure avec la composition Me2ₓOF_{y}, Me2 étant l'un quelconque de l'yttrium, du strontium, du zirconium, du niobium, de l'hafnium ou du tantale.

7. Procédé selon l'une quelconque des revendications précédentes, dans lequel l'appareil (R1) pour le dépôt chimique est un appareil pour dépôt de vapeur chimique, tel qu'un appareil pour dépôt de couche atomique (ALD) et l'appareil (R2) pour le traitement par plasma est choisi parmi l'un quelconque de : un appareil pour dépôt de vapeur chimique amélioré par plasma, un appareil pour dépôt de vapeur physique assisté par plasma ou un graveur de plasma.

8. Objet tri-dimensionnel revêtu résistant à la corrosion (100) comprenant :
un substrat profilé (10) avec une première couche de revêtement (1) conforme déposée dessus, ladite première couche de revêtement (1) est fournie comme un premier composé métallique (Me1),
une deuxième couche de revêtement (2) déposée sur la partie supérieure de ladite première couche de revêtement et fournie comme un second composé métallique (Me2), ledit premier composé métallique (Me1) et ledit second composé métallique (Me2) étant des oxydes de métal et
une troisième couche de revêtement (3, 3A),
la troisième couche de revêtement formant le revêtement (3) sur la partie supérieure de la deuxième couche de revêtement (2) étant composée d'un second composé métallique dopé par un halogène (Hl-Me2),
ledit objet tri-dimensionnel résistant à la corrosion comprenant en outre les vides de surfaces (2A) de la deuxième couche de revêtement, les surfaces (2A) étant établies après le dépôt de la deuxième couche de revêtement (2) en vertu des parties profilées (11) du substrat, tels que des retraits et/ou des perforations, la troisième couche de revêtement formant le revêtement (3A) sur lesdites surfaces profilées (2A) étant constituée d'un premier composé métallique dopé par un halogène (Hl-Me1).

9. Objet tri-dimensionnel revêtu résistant à la corrosion (100) selon la revendication 8, dans lequel la troisième couche de revêtement (3, 3A) est résistante à la corrosion par plasma, en particulier à la corrosion par plasma d'halogène.

10. Objet tri-dimensionnel revêtu résistant à la corrosion (100) selon la revendication 8, dans lequel le premier composé métallique est l'oxyde d'aluminium (Al₂O₃) et le second composé métallique étant l'oxyde d'yttrium (Y₂O₃) .

11. Objet tri-dimensionnel revêtu résistant à la corrosion (100) selon la revendication 8, dans lequel le second composé métallique est choisi parmi l'un quelconque de : l'oxyde de strontium (SrO), le dioxyde de zirconium (ZrO₂), le dioxyde de niobium (NbO₂), le dioxyde d'hafnium (HfO₂), le pentoxyde de tantale (Ta₂O₅) ou une de leurs combinaisons.

12. Objet tri-dimensionnel revêtu résistant à la corrosion (100) selon la revendication 8, dans lequel le premier composé métallique dopé par un halogène (Hl-Me1) est l'oxyfluorure d'aluminium de formule Me1ₓOF_{y}.

13. Objet tri-dimensionnel revêtu résistant à la corrosion (100) selon la revendication 8, dans lequel le second composé métallique dopé par un halogène (Hl-Me2) est u composé oxyfluorure avec la composition Me2ₓOF_{y}, Me2 étant l'un quelconque parmi l'yttrium, le strontium, le zirconium, le niobium, l'hafnium ou le tantale.

14. Objet tri-dimensionnel revêtu résistant à la corrosion (100) selon l'une quelconque des revendications 8 à 13, dans lequel le composé halogène dans la troisième couche de revêtement (3, 3A) est le fluor ou le chlore.

15. Objet tri-dimensionnel revêtu résistant à la corrosion (100) selon l'une quelconque des revendications 8 à 14, dans lequel le substrat profilé (10) est constitué d'u matériau choisi dans le groupe constitué par : un métal, un alliage métallique, le quartz, un semiconducteur et une céramique.

16. Utilisation d'un objet tri-dimensionnel revêtu (100) selon l'une quelconque des revendications 8 à 15 dans un équipement pour traitement par plasma, l'objet tri-dimensionnel revêtu étant configuré comme un composant d'équipement choisi dans le groupe constitué par : une douchette, un diffuseur pour la douchette, un socle, un support d'échantillon, une vanne, un bloc de vannes, une broche, un collecteur, un tuyau, un cylindre, un couvercle et un récipient.

17. Utilisation d'un objet tri-dimensionnel revêtu (100) selon l'une quelconque des revendications 8 à 15 dans un équipement pour traitements assistés par plasma, l'objet tri-dimensionnel revêtu étant configuré comme un composant de l'équipement choisi parmi la gravure de plasma, le dépôt de vapeur chimique amélioré par plasma et le dépôt de vapeur physique.
